(19) Europäisches Patentamt
European Patent Office
Office européen des brevets

(11) Numéro de publication: **0 422 971 A1**

(12) # DEMANDE DE BREVET EUROPEEN

(21) Numéro de dépôt: **90402462.7**

(51) Int. Cl.[5]: **G11C 19/08**

(22) Date de dépôt: **07.09.90**

(30) Priorité: **11.09.89 FR 8911845**

(43) Date de publication de la demande: **17.04.91 Bulletin 91/16**

(84) Etats contractants désignés: **DE GB**

(71) Demandeur: **COMMISSARIAT A L'ENERGIE ATOMIQUE Etablissement de Caractère Scientifique Technique et Industriel**
**31/33, rue de la Fédération**
**F-75015 Paris(FR)**

(72) Inventeur: **Arnaud, Lucile**
**Les Michallons**
**F-38250 Saint-Nizier-Du-Moucherotte(FR)**
Inventeur: **Boileau, Franck**
**Les Epinassières, Vaulnaveys-Le-Haut**
**F-38410 Uriage(FR)**

(74) Mandataire: **Mongrédien, André et al**
**c/o BREVATOME 25, rue de Ponthieu**
**F-75008 Paris(FR)**

(54) **Dispositif de coupe d'un domaine en bande d'une mémoire magnétique à lignes de Bloch.**

(57) Ce dispositif servant à l'écriture ou à la lecture d'une information dans ladite mémoire, comporte deux bandes conductrices de l'électricité (10a, 10b) parallèles de largeur au plus W, supportées par un film magnétique contenant le domaine en bande (6) de largeur l et orientées perpendiculairement au domaine, ces bandes conductrices étant espacées l'une de l'autre d'une distance G et séparées du film magnétique par une distance D, et des moyens d'alimentation (44) pour appliquer une première impulsion de courant simultanément sur les deux bandes conductrices ; il est caractérisé en ce que les paramètres l, W, G et D satisfont aux relations suivantes : $2 \leq l/D \leq 6$ ; $l/G \geq 1,1$ ; et $l/W \geq 1,3$.

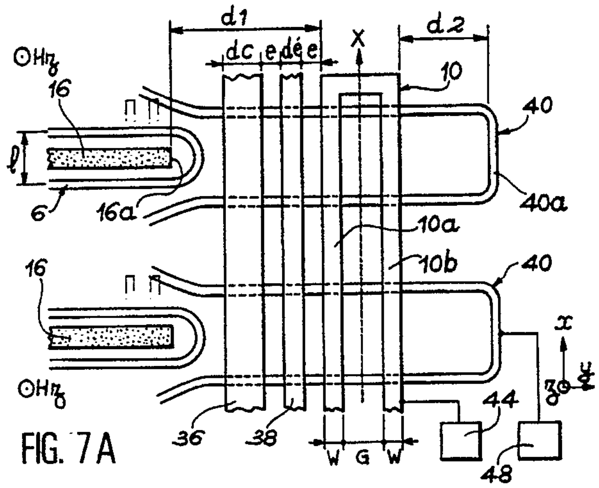


FIG. 7A

EP 0 422 971 A1

# DISPOSITIF DE COUPE D'UN DOMAINE EN BANDE D'UNE MEMOIRE MAGNETIQUE A LIGNES DE BLOCH

L'invention se rapporte à un dispositif de coupe d'un domaine en bande d'une mémoire magnétique à lignes de Bloch permettant la mémorisation d'informations binaires. Ce dispositif est utilisé aussi bien pour la lecture que pour l'écriture d'une information. Il permet en particulier de discriminer une coupe facile d'une coupe difficile du domaine en bande suivant la présence ou non d'une paire de lignes de Bloch, correspondant respectivement à l'information "1" ou "0". Cette discrimination de coupe est donc l'une des opérations essentielles d'une mémoire magnétique à lignes de Bloch.

Ce dispositif de coupe comprend de façon connue soit un conducteur électrique en épingle parcouru par un courant soit, deux conducteurs électriques sous forme de bande, parallèles entre eux, parcourus par des courants de même intensité mais de sens opposés.

Le principe de la mémoire à lignes de Bloch a été proposé en 1983 par S. Konishi dans le document EP-A-0106358 et l'article de IEEE Transactions on Magnetics, vol. MAG19 (1983) n°5, p.1838-1840 : "A new ultra-high density solid state memory : Bloch line memory".

Depuis cette date, plusieurs publications ont présenté des résultats sur les diverses fonctions d'une telle mémoire. Les fonctions d'écriture et de lecture ou respectivement transfert-in et transfert-out en terminologie anglosaxonne des paires de lignes de Bloch ont été étudiées dans différents laboratoires aux Etats-Unis et au Japon.

Les mémoires à lignes de Bloch utilisent le même matériau que les mémoires magnétiques à bulles mais ont l'avantage de ne pas être limitées par les caractéristiques du matériau contrairement à ces dernières. Elles présentent ainsi une densité de stockage beaucoup plus grande que celle des mémoires à bulles.

Les mémoires à lignes de Bloch comprennent de façon connue, comme schématisé en coupe sur la figure 1, un film magnétique 2 d'épaisseur h , épitaxié sur un monocristal 4 généralement de grenat de gallium et de gadolinium (GGG). La surface principale 7 du film magnétique 2 est parallèle au plan xy et son axe de facile aimantation F est orienté selon l'axe z perpendiculaire à cette surface principale 7.

Ce film magnétique 2 contient les domaines en bande 6 et les lignes de Bloch 8a, 8b de la mémoire, représentés de façon plus détaillé sur la figure 2 ; il supporte plusieurs niveaux de conducteurs électriques tels que 11 et 13, nécessaires au fonctionnement de la mémoire. En particulier le niveau supérieur 13 comporte des conducteurs de coupe 10. Un isolant électrique 12, appelé espaceur est prévu entre les conducteurs électriques du niveau inférieur et le film magnétique 2. De même, un isolant électrique 15 ou espaceur est prévu entre les différents niveaux de conducteurs. On note D la distance séparant les conducteurs de coupe 10 et le film 2.

Chaque domaine en bande 6 est entouré d'une paroi 14 d'une certaine épaisseur et leur "stabilisation" dans le film magnétique est assurée par des zones de stabilisation 16 formées en particulier par implantation ionique ou par gravure du film 2, sur toute son épaisseur.

La stabilisation des domaines en bande est notamment décrite dans l'article de H. Kawahara et al. IEEE Transactions on Magnetics vol.MAG.23, n°5, de septembre 1987, p.3396-3398, "A new method to stabilize multi-stripe domains for a Bloch line memory".

Les flèches 18 et 20 représentent l'aimantation de la paroi 14 et leur orientation dépend de l'information contenue dans le domaine 6 ; les flèches 18 sont orientées selon le sens de rotation des aiguilles d'une montre et les flèches 20 sont orientées selon le sens inverse. L'aimantation dans les domaines en bande est opposée à celle du reste du matériau magnétique.

Les lignes de Bloch apparaissent à chaque fois que l'aimantation dans la paroi 14 change de sens et sont perpendiculaires à la surface 7 du film 2. Les lignes de Bloch vont toujours par paires, une ligne 8a et une ligne 8b et doivent être de signe négatif pour le fonctionnement de la mémoire.

Pour une paire de lignes de Bloch 8a et 8b, l'aimantation dans la section de paroi 18 entre les deux lignes est de sens opposé à l'aimantation du reste de la paroi 20.

Le signe d'une ligne 8a, 8b correspond non pas au sens des flèches représentées sur les figures mais au sens de rotation de l'aimantation au passage de la ligne à partir de la paroi.

Quelle que soit l'orientation de l'aimantation dans un domaine, on définit une ligne de Bloch +, si la rotation de l'aimantation au passage de la ligne s'ajoute à la rotation de l'aimantation dans la paroi du domaine et on définit une ligne de Bloch -lorsque les rotations de ces deux aimantations sont opposées.

Les domaines en bande 6 comportent deux extrémités respectivement 3 et 5 appelées première et seconde têtes de bande. Ils sont extensibles et rétractables dans une direction passant par ces deux extrémités 3 et 5 lorsqu'on leur applique un champ magnétique continu de commande

$$\vec{H_z},$$

approprié, selon la direction z et orienté de la surface supérieure 7 du film vers sa surface inférieure 9. Généralement, même lorsque les domaines ne renferment aucune information "1" une ligne de Bloch négative à chaque extrémité du domaine en bande est inscrite et positionnée au préalable au fonctionnement de la mémoire.

L'organisation d'une mémoire à lignes de Bloch est similaire à celle d'une mémoire à bulles. Cette organisation est représentée schématiquement sur la figure 3. Elle comprend une zone de stockage 22, une zone d'accès 24 et des portes de transfert 26 entre la zone de stockage et la zone d'accès.

La zone de stockage est constituée des domaines en bande 6, parallèles entre eux, dont les parois 14 jouent le rôle de boucles mineures. La stabilisation des lignes et des domaines est assurée par des motifs de trame 25 perpendiculaires aux domaines et des motifs de trame 16 et 27 parallèles aux domaines.

La zone d'accès 24 comporte généralement deux conducteurs 28 et 30 isolés, disposés en chevron et un générateur 32 et un détecteur 34 de bulles magnétiques 31 à proximité de ces conducteurs.

Les informations "1" et "0" correspondent respectivement à la présence ou à l'absence d'une paire 8a-8b de lignes de Bloch dans la zone de stockage. En général, la présence et l'absence d'une bulle 31 dans la zone d'accès 24 correspondent respectivement aux informations "1" et "0" pour la lecture et à l'inverse pour l'écriture.

A l'entrée, les signaux électriques d'écriture sont convertis en information magnétique par le générateur 32. L'information est stockée dans la zone d'accès jusqu'à son remplissage. Un transfert en parallèle grâce aux portes de transfert 26 fait passer l'information de la zone d'accès vers les domaines en bande. A l'écriture, la nouvelle information doit remplacer l'ancienne ; l'écriture s'accompagne donc d'un effacement.

Pour la lecture, l'information contenue dans les domaines en bande 6 est transférée dans la zone d'accès pour être détectée ; l'information contenue dans la zone de stockage ne doit pas être détruite. Pour accéder à une information donnée, il faut que les éléments binaires correspondant se trouvent en face des portes de transfert 26.

Ces portes de transfert doivent réaliser deux fonctions : l'échange d'informations lors de l'écriture et la "duplication" lors de la lecture.

De façon connue, les portes de transfert 26 comportent un conducteur de contrôle 36, le conducteur de coupe 10 des domaines en bande, généralement en forme d'épingle, un conducteur d'écriture 38 des paires de lignes de Bloch distinct du conducteur 10 et des conducteurs d'extension 40 des domaines en bande. Le conducteur d'écriture 38 peut avoir la forme d'une bande comme représenté ou la forme d'une épingle. Par ailleurs, ce conducteur 38 peut être confondu avec le conducteur de coupe 10. Dans ce dernier cas, le conducteur 10 sert à la fois à la lecture et à l'écriture. Ces conducteurs électriques sont isolés électriquement les uns des autres ; leurs formes et leur disposition respectives sont variables. En général les conducteurs d'extension constituent le premier niveau 11 de conducteurs et les conducteurs 36, 38 et 10 constituent les autres niveaux 13. Les conducteurs 38, 10, 36 et 40 sont connectés respectivement à des sources d'alimentation électrique 42, 44, 46 et 48.

L'écriture d'une paire de lignes de Bloch (-, -) correspondant à l'information "1" (ou transfert in) nécessite différentes phases représentées sur les figures 4A-4B.

Sur la partie a de la figure 4A, le domaine en bande 6 est au repos, sa paroi 14 entoure la zone 16 de stabilisation. Un aimant permanent extérieur crée par exemple le champ de polarisation

$$\vec{H_z}.$$

Des motifs 25, orientés perpendiculairement au domaine 6 permettent de fixer la position des lignes. La ligne de Bloch de l'extrémité 3 du domaine en bande est notée Lo ; elle est toujours de signe -.

La première phase de l'écriture, représentée sur la partie b de la figure 4A, consiste à étendre le domaine en bande sous les conducteurs électriques 36, 38 et 10 par application d'un courant i approprié sur le conducteur d'extension 40. Ce courant i sera appliqué pendant toute la durée de l'écriture.

Simultanément avec l'extension, le conducteur de contrôle 36 est activé par un courant Ia ; le champ magnétique plan

$$\vec{H_{ya}} \text{ créé}$$

sous ce dernier bloque la ligne Lo d'extrémité ; ce courant la sera appliqué pendant toute la durée de l'écriture. Le domaine en bande étendu porte la référence 6a.

On effectue ensuite l'écriture à proprement parler de la paire de lignes de Bloch (-,-).

Pour ce faire, on écrit tout d'abord une paire de lignes (+, -) instable (partie c de la figure 4A) que l'on convertit ensuite en paire (-, -) stable (parties a et b de la figure 4B).

En envoyant de façon connue une impulsion de courant Ie d'environ 70 mA pendant 40 ns avec des temps de montée et de descente de 10 ns dans le conducteur d'écriture 38, le champ magnétique créé localement est suffisant pour que des boucles de Bloch horizontales soient créées. Si le courant Ie est maintenu (de 10 à 100 ns suivant les films magnétiques 2 considérés), les boucles produites "percent" et des paires de lignes de Bloch 50 de polarités opposées (+, -) sont nucléées dans la paroi 14 du domaine étendu 6a (partie c de la figure 4A).

En fait, le courant Ie déplace localement la paroi 14 du domaine. Si la vitesse de déplacement local de la paroi 14 est égale ou supérieure à la vitesse $v^o n$ de nucléation (vitesse qui ne dépend que des paramètres du film magnétique 2), il y a nucléation des boucles de Bloch dans les parties latérales 14a ou 14b de la paroi traversées par le conducteur d'écriture 38, à la surface du film 2 ou à l'interface 2-11 film-conducteur. La nucléation d'une seule paire correspondant à la seule paire (+, -) 50 est possible si on applique un champ plan extérieur

$$\overrightarrow{Hey}.$$

Seule la paroi dont l'aimantation est opposée au sens du champ

$$\overrightarrow{Hey}$$

aura une vitesse suffisante pour permettre la nucléation d'une boucle de Bloch. En présence du champ plan

$$\overrightarrow{Hey}$$

immédiatement après écriture, les lignes 50 sont séparées et la ligne + se retrouve repoussée vers l'extrémité 3 (figure 4B).

Pour convertir la paire (+, -) de lignes 50 en une paire (-, -) 52 stable, on réalise alors une coupe du domaine en bande 6a (partie a de la figure 4B) en appliquant une impulsion de courant Ic au conducteur 10 en épingle, créant un champ magnétique local vertical

$$\overrightarrow{Hcz}$$

entraînant un déplacement local des parois 14a et 14b l'une vers l'autre.

Par continuité topologique du vecteur aimantation, une ligne négative L1 est produite à l'extrémité 3 du domaine 6a qui vient d'être coupé (partie b de la figure 4B).

La bulle magnétique 54 issue de la coupe du domaine 6a, doit être évacuée dans la zone d'accès et détruite car elle n'est le support d'aucune information (partie c de la figure 4B).

D'autres schémas peuvent être considérés pour l'écriture. Par exemple, un principe proposé par Hitachi dans le document EP-A-0255044, repose sur l'hypothèse d'écriture directe de paires de lignes de Bloch négatives par production d'un point de Bloch.

Dans l'invention, on utilise le principe décrit aux figures 4A, 4B.

Le retour au repos du domaine en bande 6 (partie c de la figure 4B) est obtenu en supprimant le courant appliqué au conducteur d'extension. Parallèlement, le courant appliqué au conducteur de contrôle 36 est supprimé.

Comme on l'a dit précédemment, la vitesse de nucléation $v^o n$ des lignes de Bloch dépend des paramètres du film magnétique 2. On peut l'exprimer de la façon suivante :

$v^o n = 24a.A/h \sqrt{Ku}$

avec a le facteur gyromagnétique du film, A la constante d'échange magnétique, h l'épaisseur du film magnétique et Ku la constante d'anisotropie uniaxiale.

Cette vitesse de nucléation est modifiée en présence d'un champ magnétique plan supplémentaire

$\overrightarrow{Hey}$

comme suit :

$vn = v^{o}n + \epsilon.\pi/2.a.\sqrt{A/Ku}$ .

$\overrightarrow{Hey}$

avec $\epsilon = +1$ si l'aimantation du film 2 et le champ

$\overrightarrow{Hey}$

sont de même sens et $\epsilon = -1$ si l'aimantation et le champ

$\overrightarrow{Hey}$

sont de sens contraires.

Le principe de la lecture des informations "1" et "0" stockées dans les domaines en bande est représenté respectivement sur les figures 5 et 6A-6B. La lecture d'une information, appelée aussi transfert out, comporte plusieurs étapes.

Sur la partie a des figures 5 et 6A, le domaine en bande 6 est au repos.

La lecture d'une information ne nécessite que trois types de conducteurs électriques au lieu de quatre dans certains cas pour l'écriture ; un conducteur d'extension 40, un conducteur de coupe 10 et un conducteur de contrôle 36.

Comme pour l'opération de transfert in, la lecture nécessite d'abord l'extension du domaine en bande 6 de la zone de stockage 22 vers la zone de transfert 26 (partie b des figures 5 et 6A), puis la lecture proprement dite des paires de lignes de Bloch (parties c des figures 5 et 6A et a et b de la figure 6B).

La lecture d'un élément binaire se fait par la discrimination entre une coupe facile (figure 5) et une coupe difficile (figures 6A-6B) du domaine en bande 6a. Cette lecture est une duplication, car après l'opération de lecture, l'état du domaine 6 est le même que l'état initial.

Pendant toute l'opération de lecture, un courant i approprié est maintenu dans le conducteur d'extension 40.

Au moment de l'extension du domaine en bande 6a, un courant Ia est appliqué dans le conducteur de contrôle 36 et maintenu pendant toute l'opération de lecture afin de bloquer les lignes de Bloch du domaine 6a, et d'obtenir les deux structures de paroi de référence :

- paroi à aimantation parallèle pour la coupe facile en présence d'une paire de lignes de Bloch (figure 5) ;
- paroi à aimantation antiparallèle pour la coupe difficile en l'absence d'une paire de lignes de Bloch (figures 6A, 6B).

Ensuite on applique une impulsion de courant Ic (parties c des figures 5 et 6A) sur le conducteur de coupe 10. La présence de lignes de Bloch permet une coupure à courant faible du domaine en bande, conduisant à la formation d'une bulle 56 qui peut être lue par le détecteur de bulles 34 alors que l'absence de lignes de Bloch ne permet la coupure du domaine en bande qu'avec des courants plus élevés que celui nécessaire à la coupe facile.

L'application du courant Ic sur le conducteur de coupe 10 crée un champ magnétique local

$\overrightarrow{Hcz}$.

Lorsque le conducteur en épingle est positionné perpendiculairement au domaine 6a à tester et si le champ

$\overrightarrow{Hcz}$

local s'ajoute au champ de polarisation

$\overrightarrow{Hz}$

du domaine 6a, il est possible de couper le domaine ; si les aimantations 18 et 20 des parois 14a et 14b pointent dans la même direction, sous l'épingle de coupe, il est facile de couper le domaine par celle-ci (figure 5). Si les aimantations des parois 14a et 14b pointent dans des directions opposées sous l'épingle de coupe, il est difficile de couper le domaine par celle-ci (figure 6A).

On définit la marge de coupe comme étant la différence entre le courant élevé nécessaire à la coupe difficile et le courant plus faible nécessaire à la coupe facile. On considère qu'on n'obtient pas de marge de coupe si on a la même répartition en courant pour les deux types de coupe.

Le retour au repos du domaine en bande est encore obtenu en supprimant les courants appliqués aux conducteurs d'extension et de contrôle (parties e et c des figures 5 et 6B)

L'invention a justement pour objet un dispositif électrique de coupe d'un domaine en bande, utilisable aussi bien pour l'écriture que pour la lecture d'une information, présentant une marge de coupe suffisante pour discriminer les coupes faciles des coupes difficiles. Le dispositif de coupe de l'invention est soit du type en épingle, soit constitué de deux conducteurs parallèles. Il peut être utilisé dans les différentes configurations décrites précédemment, c'est-à-dire associé à un conducteur de contrôle et à un conducteur d'écriture ou à un conducteur de contrôle seul. Dans ce dernier cas, il peut jouer le rôle de conducteur d'écriture.

La discrimination entre les coupes faciles et difficiles du domaine en bande par le dispositif de coupe dépend de la largeur W du (ou des) conducteur(s) le constituant (voir figure 1), de la distance G (ou gap) séparant les deux branches du conducteur en épingle ou les deux conducteurs et de la distance D séparant ce ou ces conducteurs du film magnétique 2.

Dans la publication Y. Hidaka et al. IEEE Transactions on Magnetics, vol. MAG 19 (1983) n°5, p.1841-1843 "Experimental confirmation of fundamental functions for a novel Bloch line memory" des marges de coupe ont été obtenues pour une épingle dont le gap G vaut 4 µm ; l'impulsion Ic doit avoir un temps de montée soit très faible de 40 ns, soit très élevé de 2,0 µs.

Avec un gap de 6 µm comme prévu dans le document S. Konishi et al., IEEE Transactions on Magnetics vol. MAG, 20 (1984) p.1129-1134, "Bloch line memory, an approach to gibabit memory", il faut une impulsion de 3ns de temps de montée.

Dans le document K. Matsuyama et al. J. Appl. Phys. 6 3 (8) (1988), p.3171-3173 "Controlling Bloch lines and domain chopping for multiple stripes aligned in parallele", un conducteur en chevron a permis d'obtenir une marge de coupe plus grande que dans le cas précédent mais l'impulsion de courant Ic doit avoir un temps de montée très court de 7 ns.

Dans les documents de J.C. Ww et F.B. Humphrey, IEEE Transactions on Magnetics vol. MAG 22, n°5, (1986) p.790-792 "Operation of a VBL memory read, write gate" et IEEE Transactions on Magnetics MAG 21, n°5 (1985) p.1773-1775 "Operation of VBL memory write gate", une marge de coupe, suffisante est obtenue avec un gap de 2 µm et une impulsion Ic de 15 ns de temps de montée.

Les marges obtenues dans ces différents documents reflètent une apparente incohérence sur les paramètres du conducteur de coupe à respecter. Elles sont le plus souvent proposées pour des impulsions de courant de très faible temps de montée (<50ns). Ce qui est difficile à réaliser en électronique, surtout pour une mémoire dans laquelle le conducteur de coupe, traversant plusieurs domaines en bande (50 à 100), a une résistance d'environ 100 ohms.

Par ailleurs, les tests proposés dans la littérature ne prennent pas en compte une éventuelle destruction de l'information au cours de la lecture lors de l'opération de coupe des domaines. La nucléation des lignes de Bloch est un phénomène qui peut se produire à un moment inopportun. L'interaction entre les lignes parasites produites et les lignes servant effectivement au stockage de l'information peut entraîner une perte d'informations.

L'invention a justement pour but un dispositif de coupe d'un domaine en bande d'une mémoire à lignes de Bloch permettant notamment de remédier aux inconvénients ci-dessus. En particulier, elle permet l'obtention d'une marge de coupe quel que soit le matériau considéré lors de la lecture des lignes (transfert-out ou duplication) et lors de la conversion paire (+,-) en paire (-,-) dans l'écriture des paires de lignes (transfert-in) ; ainsi qu'une opération de coupe sans création de lignes de Bloch verticales parasites.

De façon plus précise l'invention a pour objet un dispositif de coupe d'un domaine en bande de largeur l d'une mémoire à lignes de Bloch, servant à l'écriture ou à la lecture d'une information dans ladite mémoire, ce dispositif comportant deux bandes conductrices de l'électricité parallèles de largeur au plus W, supportées par un film magnétique contenant le domaine en bande et orientées perpendiculairement au domaine, ces bandes conductrices étant espacées l'une de l'autre d'une distance G et séparées du film

magnétique par une distance D, et des moyens d'alimentation pour appliquer une première impulsion de courant simultanément sur les deux bandes conductrices, ce dispositif étant caractérisé en ce que les paramètres I, W, G et D satisfont aux relations suivantes : $2 \leq 1/D \leq 6$ ; $I/G \geq 1{,}1$ ; et $I/W \geq 1{,}3$.

Ce dispositif de coupe permet une bonne marge de coupe quel que soit le matériau magnétique utilisé.

Afin d'empêcher toute création de lignes de Bloch inopportune lors de la coupe du domaine en bande, les moyens d'alimentation des deux bandes conductrices délivrent une première impulsion de courant ayant un temps de montée Tm supérieur au temps de montée To d'une seconde impulsion de courant minimum nécessaire à la nucléation des lignes de Bloch.

Ce temps de montée To minimum nécessaire à la nucléation des lignes de Bloch a été déterminé par les inventeurs ; il satisfait à l'équation (1) $To = (Hcz/vn).(h/8Ms/\ln(1 + h^2/l^2))$ dans laquelle

$$\vec{Hcz}$$

est la valeur du champ magnétique créée dans le film par la première impulsion selon une direction perpendiculaire à la surface du film ; h est l'épaisseur du film magnétique ; ln est le logarithme népérien ; Ms est l'aimantation à saturation du film magnétique et vn est la vitesse de nucléation des lignes de Bloch avec $vn = (24a.A/h \sqrt{Ku}) + \epsilon.\pi/2.a \sqrt{A/Ku}$.

$$\vec{Hy}$$

où a est le f gyromagnétique du film magnétique ; A est la constante d'échange magnétique ; Ku est la constante d'anisotropie uniaxiale du film magnétique ;

$$\vec{Hy}$$

est le champ créé dans le plan du film au moins en partie par la première impulsion et $\epsilon$ vaut +1 respectivement -1, lorsque l'aimantation magnétique de la paroi du domaine et le champ

$$\vec{Hy}$$

sont respectivement de même signe et de signes opposés.

Pour toute impulsion de temps de montée Tm>To, la paroi du domaine se propage à une vitesse inférieure à vn ; il n'y a donc pas de lignes de Bloch nucléées lors de l'opération de coupe.

Pour toute impulsion de temps de montée Tm<To, la paroi du domaine se propage à une vitesse égale à vn et il y a nucléation de lignes de Bloch. En particulier, Tm vaut environ 2To.

Selon l'invention,

$$\vec{Hy}$$

représente le champ plan

$$\vec{Hcy}$$

seul correspondant à la composante dans le plan xy du champ induit dans le film magnétique par le courant Ic parcourant le conducteur de coupe, ou additionné d'un champ extérieur supplémentaire

$$\vec{Hey}$$

appliqué le long du domaine en bande, lors de la coupe, si nécessaire.

Les bandes conductrices du dispositif de coupe de l'invention constituent, de préférence, les deux branches d'un conducteur en épingle, ce qui permet l'utilisation d'une seule source d'alimentation électrique pour appliquer la première impulsion de courant à ces bandes conductrices. Toutefois, il est possible

d'utiliser deux conducteurs électriques distincts, alimentés par deux impulsions de courant de même intensité mais de sens opposés. Par ailleurs, ces deux branches ont de préférence la même largeur W, mais l'utilisation de branches de largeur distincte n'est pas exclue. Dans ce dernier cas, W représente la largeur de la branche la plus large.

D'autres caractéristiques et avantages de l'invention ressortiront mieux de la description qui va suivre donnée à titre illustratif et non limitatif.

La description de l'invention se réfère aux dessins annexés dans lesquels :

- la figure 1, déjà décrite, représente en coupe une partie d'une mémoire à lignes de Bloch, montrant l'agencement des conducteurs de coupe sur le film magnétique ;
- la figure 2, déjà décrite, représente un domaine en bande, en perspective, de la mémoire de la figure 1 ;
- la figure 3, déjà décrite, représente en vue de dessus l'organisation d'une mémoire à lignes de Bloch ;
- les figures 4A, 4B, déjà décrites, représentent les différentes phases de l'écriture d'une paire de lignes de Bloch dans une mémoire à lignes de Bloch ;
- les figures 5 et 6A, 6B, déjà décrites, représentent respectivement les différentes phases de la lecture d'une information "1" et "0" dans une mémoire à lignes de Bloch ;
- les figures 7A et 7B représentent en vue de dessus deux agencements possibles du conducteur en épingle du dispositif de coupe de l'invention dans une mémoire à lignes de Bloch ;
- la figure 8 donne le courant de lecture Il en mA du dispositif de coupe de l'invention en fonction du champ de polarisation

$$\vec{Hz} \text{ en A/m ;}$$

- la figure 9 donne le pourcentage de coupes faciles 64 et difficiles 66 du dispositif de l'invention en fonction du courant de coupe en mA ; et
- la figure 10 donne la répartition du champ magnétique en A/m induite dans le film magnétique par le dispositif de coupe de l'invention parcouru par un courant de 1A.

Le dispositif de coupe selon l'invention peut être utilisé dans une mémoire à lignes de Bloch telle que décrite précédemment en référence aux figures 1 à 6 pour écrire l'information "1", par écriture (ou nucléation) d'une paire de lignes de Bloch et écrire l'information "0" par effacement d'une paire de lignes de Bloch. Il permet en outre la lecture des informations stockées dans les domaines en bande sans risque de les détruire.

Le dispositif de coupe selon l'invention, représenté sur les figures 7A et 7B est constitué d'un conducteur en épingle 10 comportant deux branches 10a et 10b, respectivement de largeur W, séparées par la distance G.

Dans la description qui suit, on notera les paramètres l/D, l/G et l/W respectivement par les lettres x, k et b ; l est la largeur du domaine 6 et D est la distance séparant le conducteur de coupe 10 du film magnétique 2.

Conformément à l'invention les paramètres x, k et b doivent satisfaire aux conditions suivantes :

$2 \leq x \leq 6$ ; $k \geq 1{,}1$ et $b \geq 1{,}3$

En outre, les motifs 16 verticaux de stabilisation des domaines en bande 6 sont constitués par des gravures pratiquées dans le film magnétique.

Conformément à l'invention le conducteur 10 en épingle doit être positionné perpendiculairement aux gravures verticales 16 mais décalé par rapport à ces gravures 16. La distance séparant l'extrémité 16a des gravures et la branche 10a du conducteur 10 la plus proche de l'extrémité 16a est notée d1.

Le conducteur de coupe 10 de l'invention est associé à un conducteur d'extension 40, à un conducteur de contrôle 36 et éventuellement à un conducteur d'écriture 38, lorsque l'on désire écrire une paire de lignes de Bloch dans la mémoire. Lorsque l'on désire lire les informations stockées, on peut soit supprimer le conducteur d'écriture, soit ne pas l'activer.

Comme représenté sur la figure 7A, le conducteur de coupe 10 peut être utilisé dans une structure à deux niveaux de conducteurs, le premier niveau de conducteurs étant celui du conducteur d'extension 40 et le second niveau celui des conducteurs de coupe 10, d'écriture 38 et de contrôle 36. Par premier niveau de conducteurs, il faut comprendre le niveau de conducteurs le plus proche du film magnétique 2 (niveau 11 sur la figure 1).

Selon l'invention, le conducteur de coupe 10 est disposé, au niveau des domaines 6, perpendiculairement au conducteur d'extension 40, ce dernier ayant localement la forme d'un U dont les branches sont disposées dans le prolongement du domaine 6 correspondant et symétriquement par rapport aux gravures

16 ; la largeur séparant les branches du U du conducteur 40 est en outre supérieure à la largeur l du domaine en bande. Le conducteur 40 s'étend au-delà des conducteurs 36, 38 et 10. On note d2 la distance séparant la branche 10b du conducteur de coupe 10 et la base 40a des U du conducteur d'extension.

De façon à obtenir la marge de coupe la plus importante entre les coupes faciles et difficiles des domaines en bande, on choisit d2≧2l.

Dans cette configuration à deux niveaux de conducteurs, les branches 10a, 10b du conducteur de coupe 10 de l'invention sont disposées parallèlement au conducteur d'écriture 38 et au conducteur de contrôle 36 ayant chacun la forme d'une bande de largeur constante ; le conducteur d'écriture 38 est disposé par exemple entre le conducteur de contrôle 36 et le conducteur de coupe 10, le conducteur de contrôle étant le conducteur le plus proche de l'extrémité 16a des gravures 16.

Dans cette configuration, d1 est égal ou supérieur à dc+dé+l+2e où dc et dé représentent respectivement la largeur des conducteurs de contrôle et d'écriture, 1 représente la largeur des domaines en bande 6 et e représente l'espacement minimum entre les conducteurs électriques d'un même niveau ; en particulier e est voisin de 1 micromètre.

Comme représenté sur la figure 7B, le conducteur de coupe 10 selon l'invention peut aussi être utilisé dans une structure à trois niveaux de conducteurs, le premier niveau étant celui du conducteur d'extension 40, le second niveau étant celui du conducteur de contrôle 36a et le troisième niveau étant celui du conducteur de coupe 10 et du conducteur d'écriture 38.

Dans cette configuration, les branches 10a et 10b du conducteur de coupe 10 sont toujours parallèles au conducteur d'écriture 38 et perpendiculaires au conducteur d'extension 40. En revanche, le conducteur de contrôle 36a est perpendiculaire aux branches 10a, 10b du conducteur de coupe 10. Dans cette configuration, on utilise de préférence d1≧dé+l+e.

En plus des paramètres x, k et b donnés ci-dessus, le dispositif de coupe selon l'invention doit satisfaire à l'équation Tm>To où To est le temps de montée de l'impulsion de courant qui correspond à la vitesse de propagation des parois vn. Autrement dit, To est le temps minimum de montée de l'impulsion nécessaire à la nucléation des lignes de Bloch.

L'équation (1) donnée précédemment de To n'est vraie que pour les films magnétiques pour lesquels To est > >Ts avec Ts=h/8Ms.u où u vaut $a/b.\sqrt{A/Ku}$ . En général Ts est de l'ordre de 10 ns alors que To vaut plusieurs dizaines de nanosecondes.

Pour' un film magnétique 2 de 2,75 micromètres, épitaxié sur un monocristal 4 de GGG ayant une aimantation à saturation 4 $\pi$Ms=129 T et une vitesse de nucléation $v^o$n=27 m/s, les inventeurs ont réalisé plusieurs conducteurs de coupe se distinguant les uns des autres par la valeur des paramètres D, G et W du conducteur de coupe en épingle. En outre, ils ont modifié la largeur 1 des domaines en bande et la valeur de Tm. Les marges de coupe de ces différents dispositifs ont été mesurées. Les résultats sont donnés dans le tableau I ci-après.

Il ressort clairement de ce tableau que les marges de coupe, entre les coupes difficiles et faciles des domaines en bande, non nulles sont obtenues pour x allant de 2 à 6, k au moins égal à 1,1 et b au moins égal à 1,3 avec Tm>To. To est égal à 253 ns pour un champ magnétique de coupe

$$\vec{Hcz}$$

de 376 A/m.

Pour les échantillons 1 et 3, il a été obtenu les marges de lecture représentées sur la figure 8. Ces marges de lecture sont données par la valeur du courant de lecture Il appliqué au conducteur de coupe en fonction du champ de polarisation

$$\vec{Hz}.$$

Les courbes 60a et 60b sont relatives respectivement à 100% de coupes faciles et à 100% de coupes difficiles pour l'échantillon 1. Les courbes 62a et à 62b sont relatives respectivement à 100% de coupes faciles et à 100% de coupes difficiles pour l'échantillon 3.

Avec x=2,35, k=1,18, b=2,35 et Tm=500 ns (correspondant à l'exemple 6), on a obtenu une marge de coupe m de 3 mA comme cela ressort clairement de la figure 9 donnant le % de coupes en fonction du courant Ic appliqué au conducteur de coupe 10. Les droites 64 et 66 correspondent respectivement au % de coupes faciles et difficiles. Le champ de polarisation

$$\vec{Hz}$$

était de 180A/m.

Dans cette même configuration, on a tracé sur la figure 10 les variations du champ plan

$$\vec{Hcy}$$

et du champ perpendiculaire

$$\vec{Hcz}$$

induites par le conducteur de coupe dans le film magnétique lorsqu'il est parcouru par un courant

$$\vec{Ic}$$

d'un ampère. Ces variations ont été tracées pour x=0, ce qui correspond à une coïncidence de l'axe des x et de l'axe de symétrie X (figure 7A) du conducteur de coupe, et pour z=3 µm ce qui correspond à la valeur du champ calculée au milieu d'un film magnétique d'épaisseur h=2 µm avec D=2 µm.

L'axe des abscisses correspond aux variations des champs selon l'axe y, autrement dit le long de la paroi du domaine.

Sur cette figure, on peut donc voir que la coupe du domaine a lieu pour un champ

$$\vec{Hcz}$$

maximum sur une longueur de paroi d'environ 2µm.

TABLEAU I

| Échantillons n° | L (µm) | W (µm) | G (µm) | D (µm) | x | k | b | Tm (ns) | marge de coupe (mA) |
|---|---|---|---|---|---|---|---|---|---|
| 1 | 5,4 | 2 | 2 | 2 | 2,7 | 2,7 | 2,7 | 500 | 13 |
| 2 | " | 2 | 3 | 2 | " | 1,8 | " | " | 4 |
| 3 | " | 2 | 4 | 2 | " | 1,35 | " | | 4 |
| 4 | " | 4 | 2 | 2 | " | 2,7 | <u>1,35</u> | " | 3 |
| 5 | " | 4 | 6 | 2 | " | (0,9) | " | " | 0 |
| 6 | 4,7 | 2 | 4 | 2 | 2,35 | 1,18 | 2,35 | 500 | 3 |
| 7 | " | " | " | " | " | " | " | (50) | 0 |
| 8,9,10 | 5,9 | " | " | 1 | 5,9 | 1,43 | 2,95 | 500/1000/ 2000 | 5 |
| 11,12,13 | " | 4 | 10 | 1 | " | (0,59) | 1,48 | " " | 0 |
| 14,15,16 | 5,1 | 2 | 2 | 2 | 2,55 | 2,55 | 2,55 | " | 8 |
| 17,18,19 | 5,1 | " | " | 2 | 2,55 | 2,55 | 2,55 | " | 3 |
| 20,21,22 | 5,6 | " | " | 2 | 2,8 | 2,8 | 2,8 | " | 12 |
| 23,24,25 | 6,3 | " | " | 0,5 | (12,6) | 3,15 | 3,15 | " | 0 → lecture impossible ou destructive |

- les chiffres entre parenthèses correspondent à des valeurs hors spécification
- les chiffres soulignés correspondent à des valeurs limites.

**Revendications**

1. Dispositif de coupe d'un domaine en bande de largeur l d'une mémoire à lignes de Bloch, servant à l'écriture ou à la lecture d'une information dans ladite mémoire, ce dispositif comportant deux bandes conductrices de l'électricité (10a, 10b) parallèles de largeur au plus W, supportées par un film magnétique (2) contenant le domaine en bande (6) et orientées perpendiculairement au domaine, ces bandes conductrices étant espacées l'une de l'autre d'une distance G et séparées du film magnétique par une distance D, et des moyens d'alimentation (44) pour appliquer une première impulsion de courant (Ic) simultanément sur les deux bandes conductrices, ce dispositif étant caractérisé en ce que les paramètres l, W, G et D satisfont aux relations suivantes :
$2 \leq l/D \leq 6$ ; $l/G \geq 1{,}1$ ; et $l/W \geq 1{,}3$.

2. Dispositif selon la revendication 1, caractérisé en ce que les moyens d'alimentation (44) délivrent une première impulsion de courant ayant un temps de montée Tm supérieur au temps de montée To d'une seconde impulsion de courant minimum nécessaire à la nucléation des lignes de Bloch.

3. Dispositif selon la revendication 1 ou 2, caractérisé en ce que l'impulsion de courant minimum To satisfait à l'équation :

$$To=(\overrightarrow{Hcz}/vn).(h/8Ms/ln(1+h^2/l^2))$$

dans laquelle

$$\overrightarrow{Hcz}$$

est la valeur du champ magnétique créé dans le film (2) par la première impulsion selon une direction perpendiculaire à la surface (7) du film ; h est l'épaisseur du film magnétique ; ln est le logarithme népérien ; Ms est l'aimantation à saturation du film magnétique et vn est la vitesse de nucléation des lignes de Bloch (8a, 8b) avec :

$$vn=(24a.A/h\sqrt{Ku})+\varepsilon\pi/2a\sqrt{A/Ku}.\overrightarrow{Hy}$$

où a est le facteur gyromagnétique du film magnétique ; A est la constante d'échange magnétique ; Ku est la constante d'anisotropie uniaxiale du film magnétique ;

$$\overrightarrow{Hy}$$

est le champ créé dans le plan du film au moins en partie par la première impulsion et $\varepsilon$ vaut +1 respectivement -1, lorsque l'aimantation magnétique de la paroi (14) du domaine (6) et le champ

$$\overrightarrow{Hy}$$

sont respectivement de même signe et de signes opposés.

4. Dispositif selon l'une quelconque des revendications 1 à 3, caractérisé en ce que les deux bandes conductrices (10a, 10b) constituent les deux branches d'un conducteur en épingle (10).

5. Dispositif selon l'une quelconque des revendications 2 à 4, caractérisé en ce que Tm est choisi de l'ordre de 2To.

6. Dispositif selon l'une quelconque des revendications 1 à 4, caractérisé en ce que les bandes conductrices (10a, 10b) sont associées à un conducteur d'extension (40) du domaine comportant une partie en U dont les branches sont parallèles au domaine en bande.

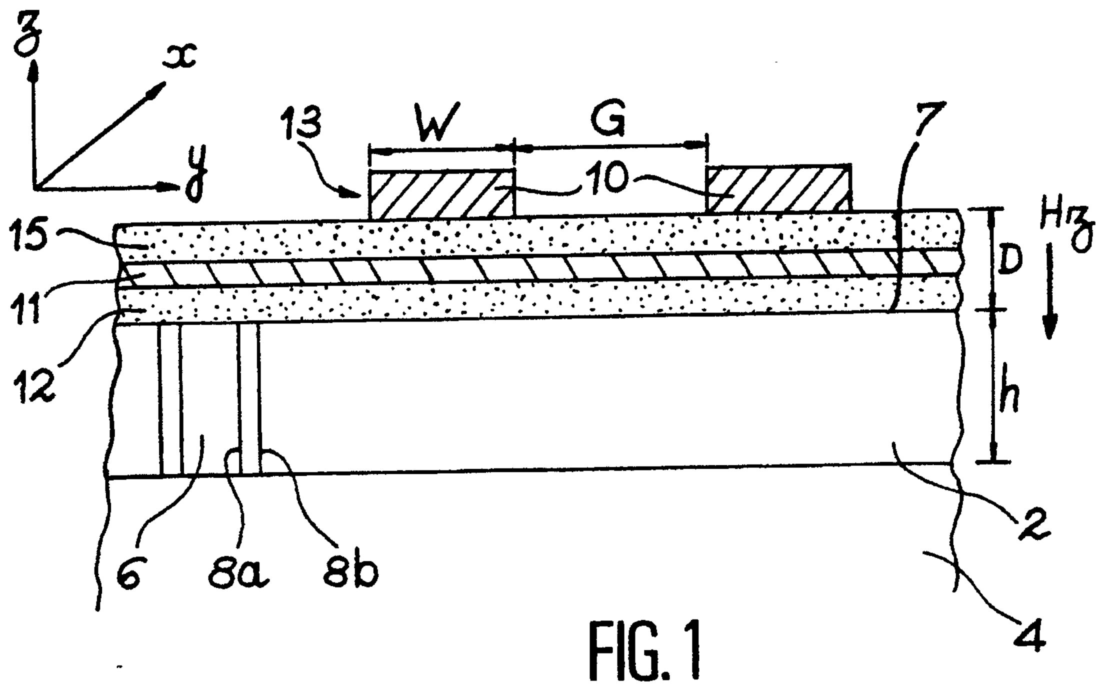
z
x
y
13
W
G
10
7
15
11
12
D
h
Hz
6
8a
8b
2
4

FIG. 1

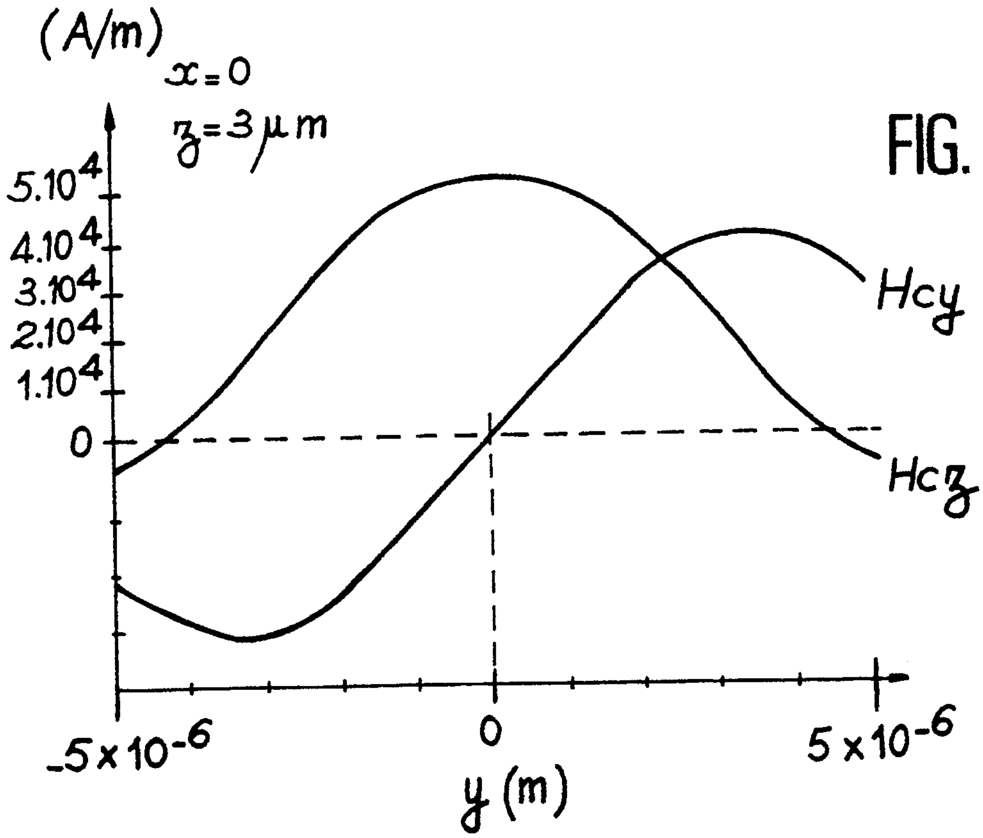
(A/m)
x = 0
z = 3 μm
5.10^4
4.10^4
3.10^4
2.10^4
1.10^4
0
Hcy
Hcz
-5 x 10^-6
0
5 x 10^-6
y (m)

FIG. 10

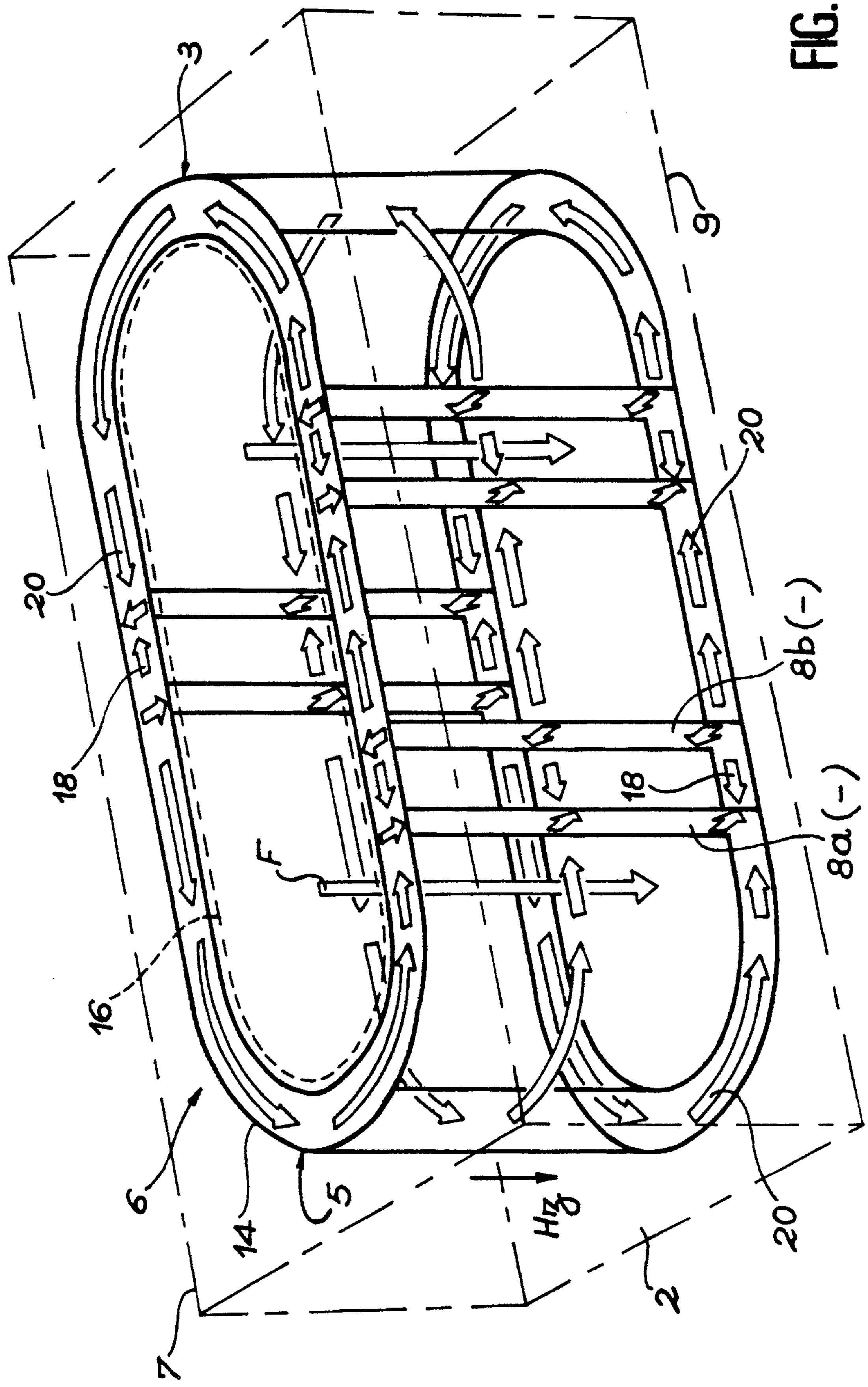


FIG. 2

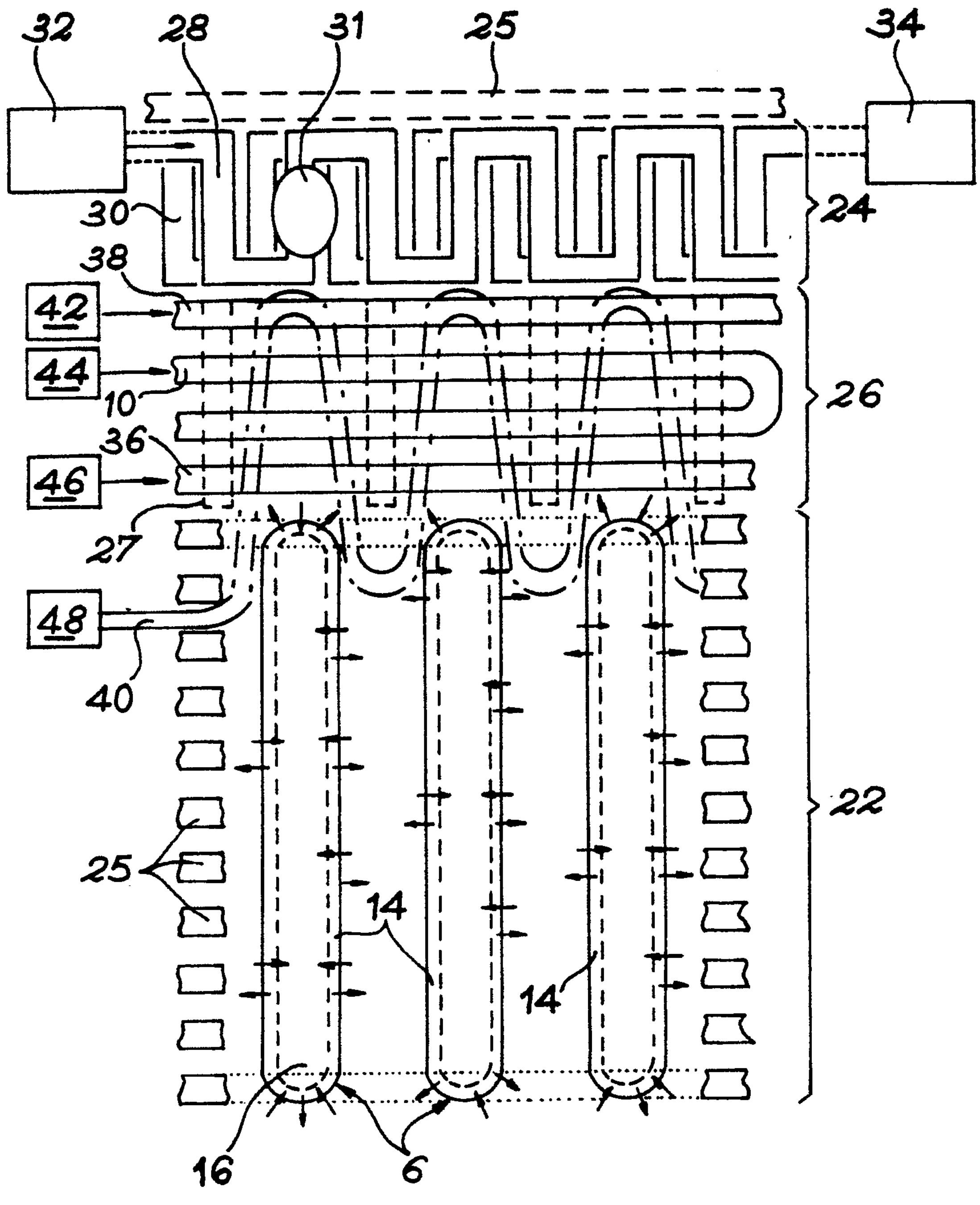


FIG. 3

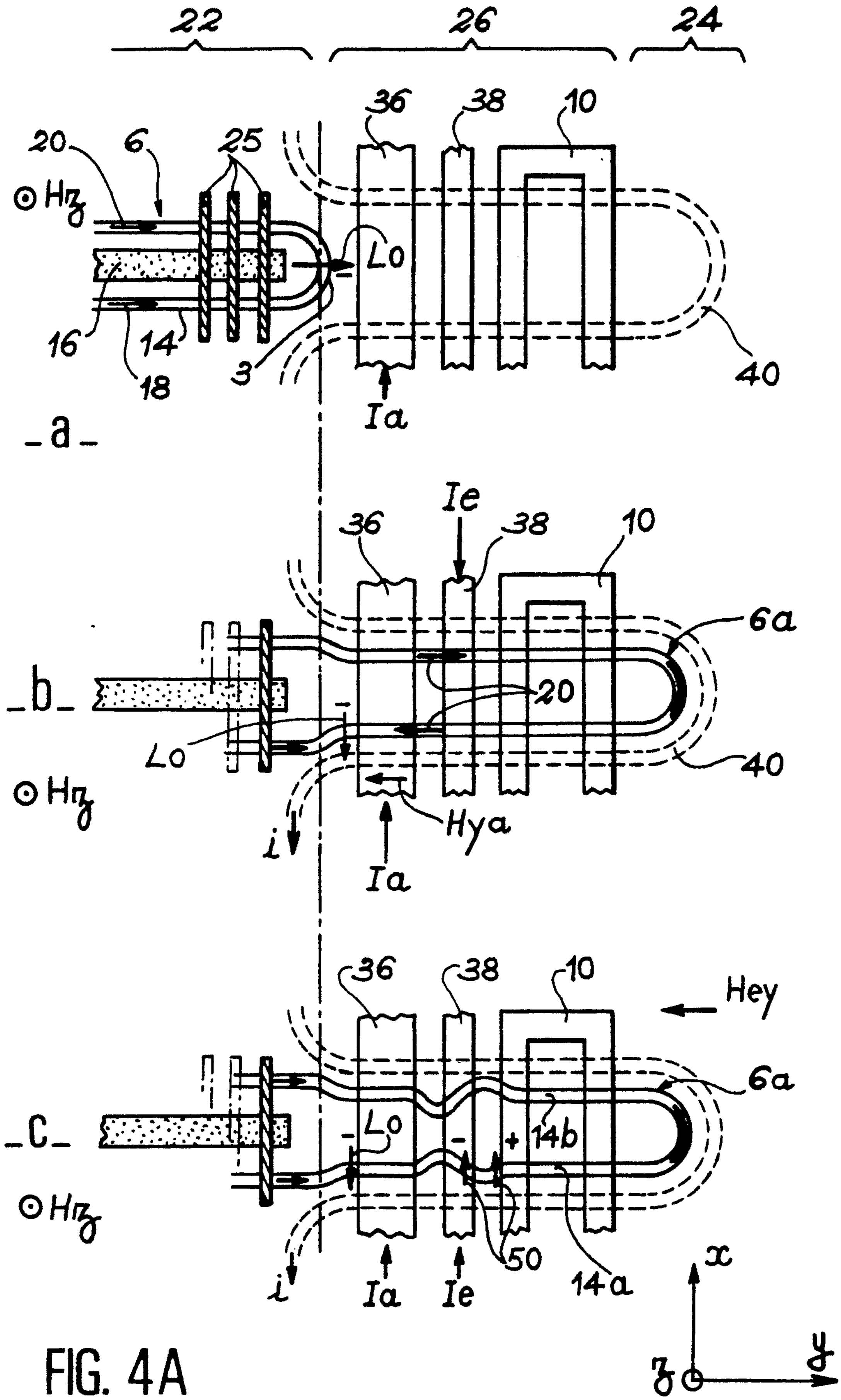
22
26
24
36
38
10
20
6
25
Hz
Lo
16
14
18
3
40
Ia
_a_
Ie
6a
20
_b_
Lo
i
Hya
Hey
14b
_c_
50
14a
Ie
x
y
z

FIG. 4A

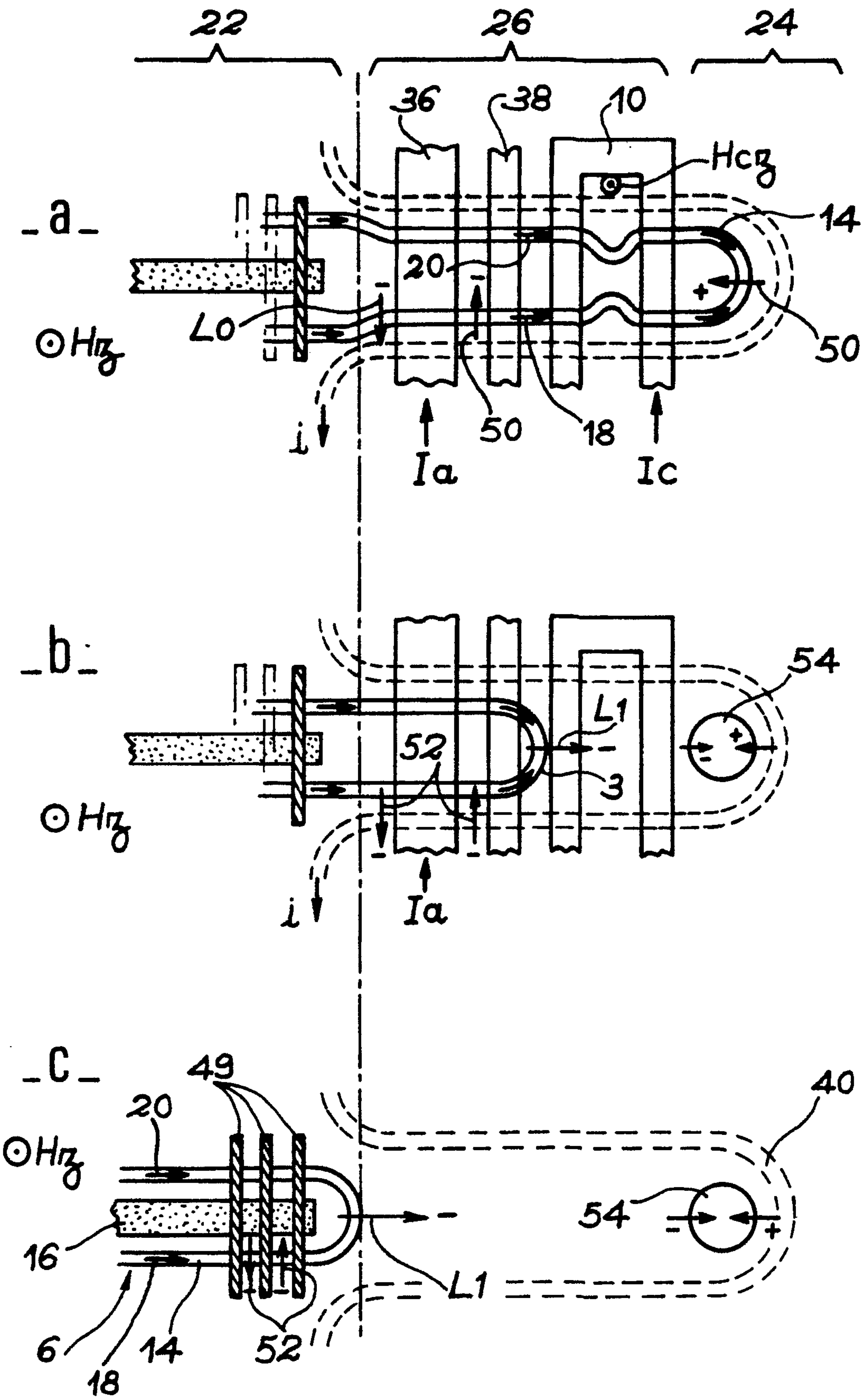
22
26
24
36
38
10
Hcz
14
_a_
20
Lo
50
⊙Hz
i
Ia
50
18
Ic
_b_
54
L1
52
3
⊙Hz
i
Ia
_c_
49
40
20
⊙Hz
54
16
L1
6
18
14
52

FIG. 4B

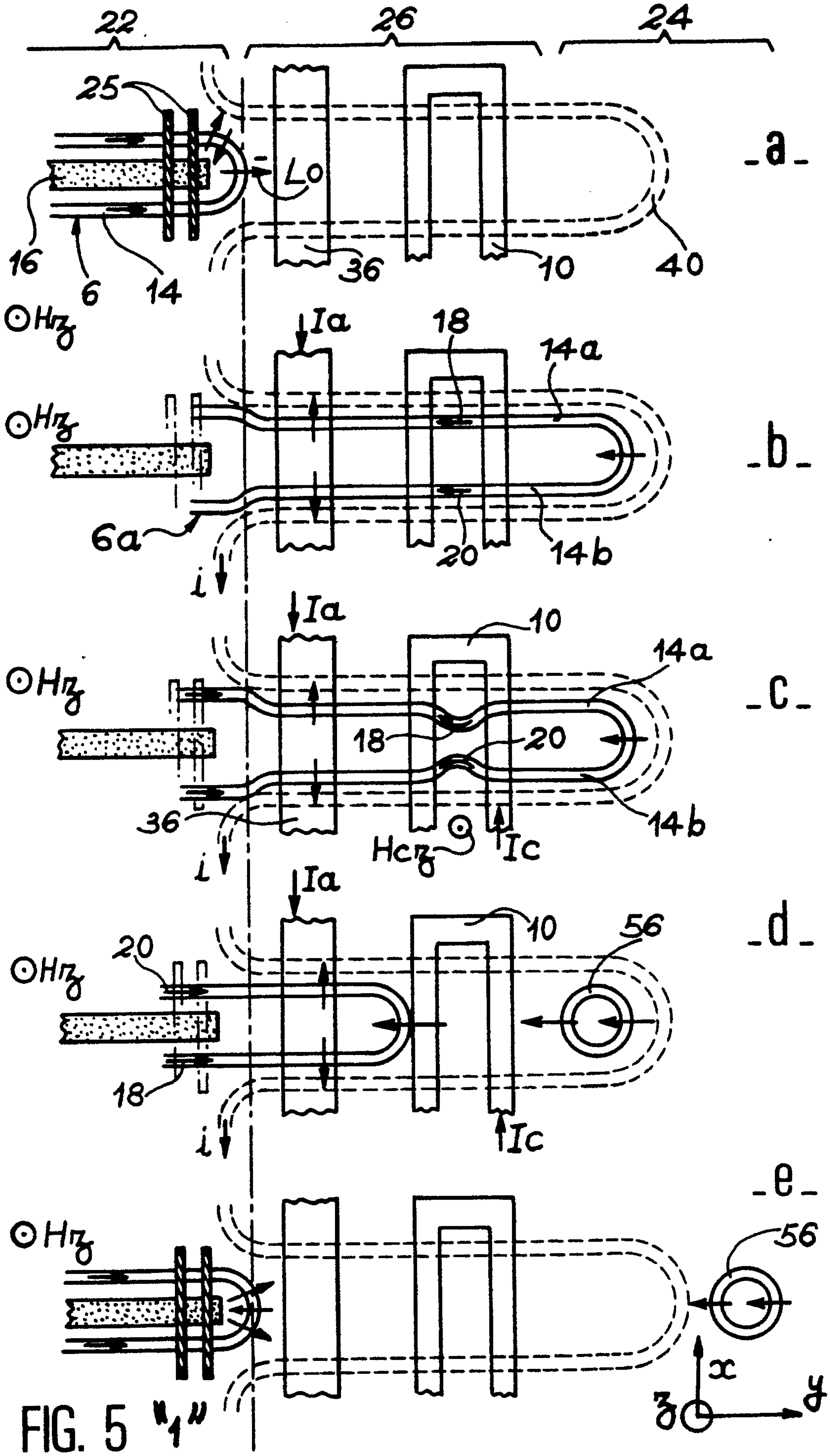
22
26
24
25
Lo
16
6
14
36
10
40
Hz
a
Ia
18
14a
b
6a
i
20
14b
10
c
18
20
36
Hcz
Ic
d
20
56
18
e
56
x
y
z

FIG. 5 "1"

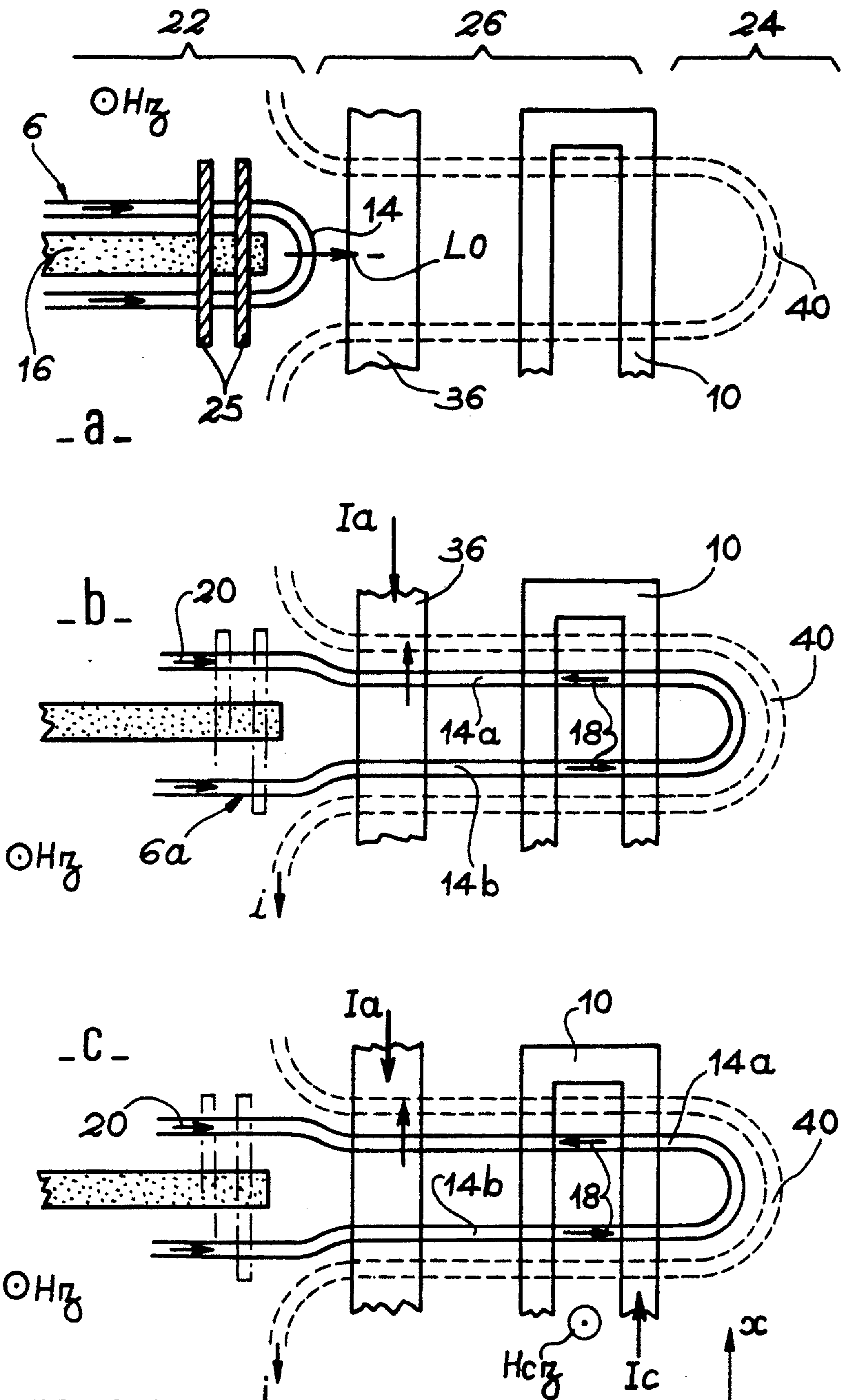
22
26
24
⊙Hz
6
14
L0
40
16
25
36
10
-a-
Ia
36
10
-b-
20
40
14a
18
⊙Hz
6a
14b
i
Ia
10
-c-
14a
20
40
14b
18
⊙Hz
Hcz
Ic
i
x
y
z

FIG. 6 A "o"

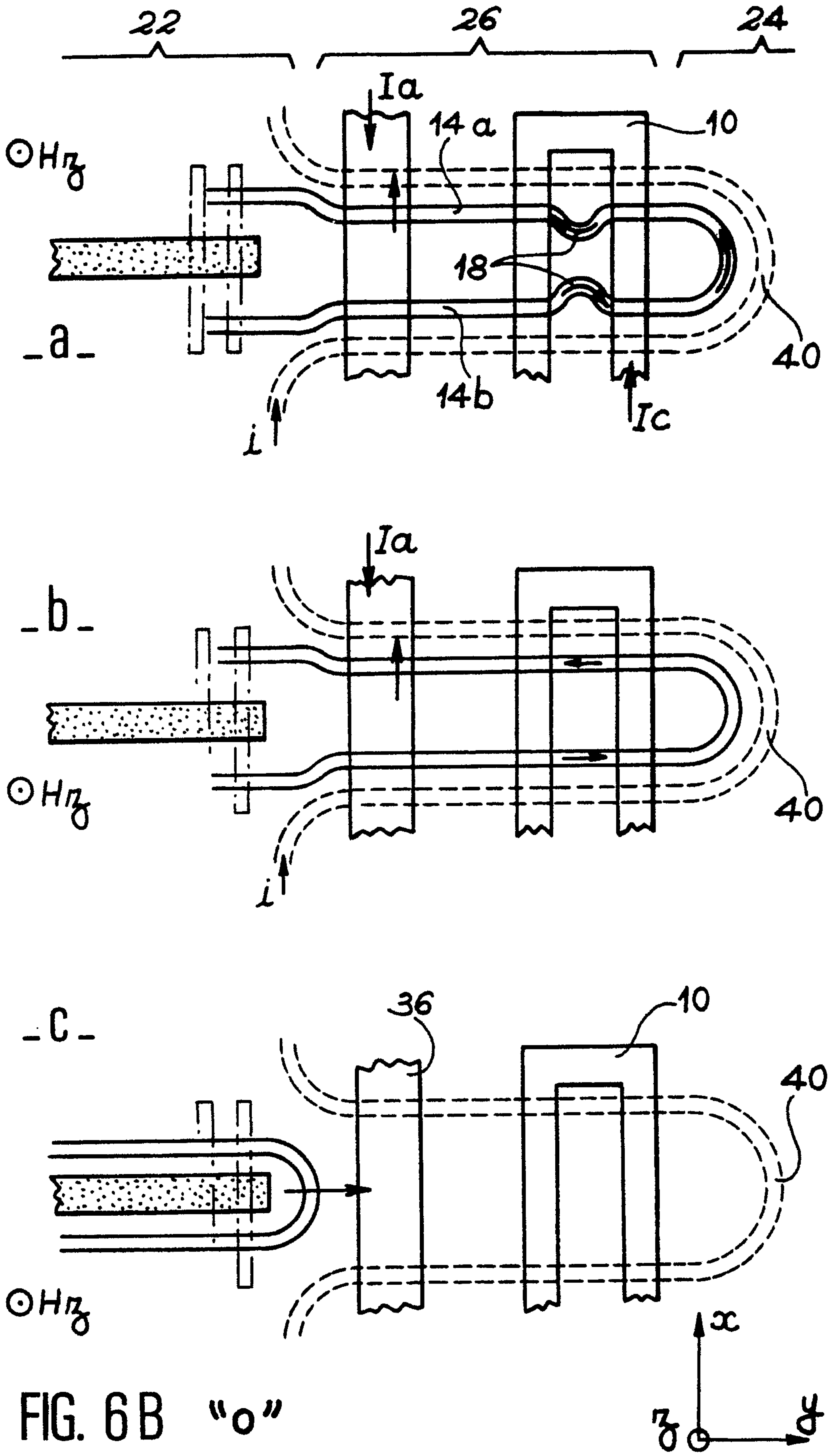


FIG. 6B "o"

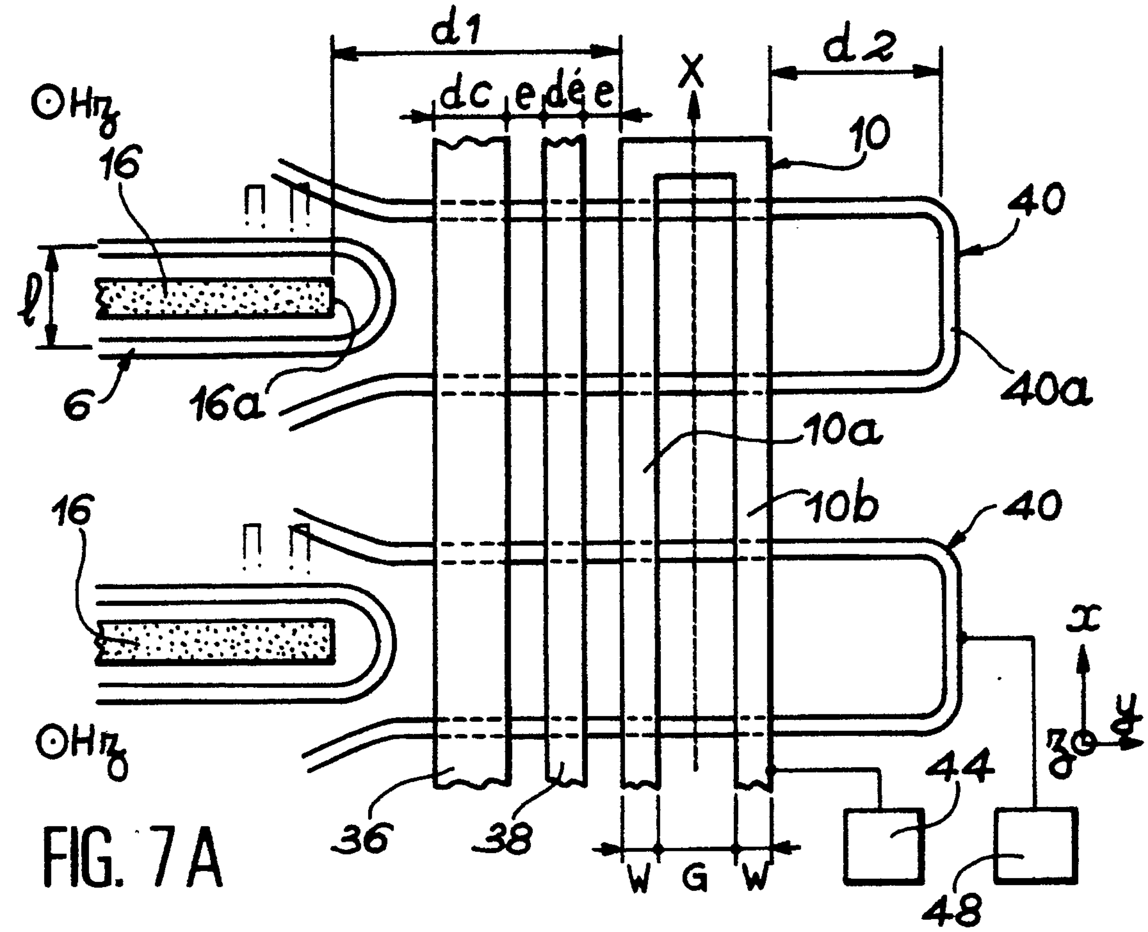
d1
d2
X
dc e dé e
⊙Hz
16
10
40
ℓ
40a
6
16a
10a
10b
40
16
x
y
z
⊙Hz
44
36
38
W G W
48

FIG. 7A

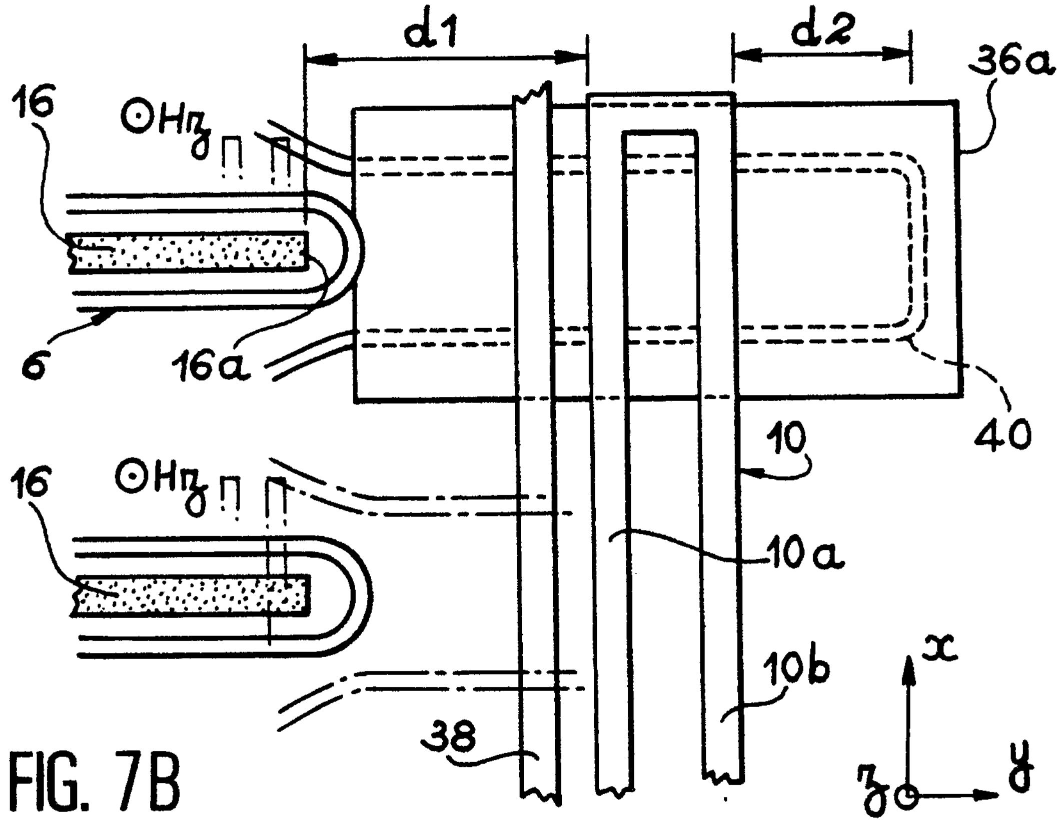
d1
d2
36a
16
⊙Hz
6
16a
40
10
16
⊙Hz
10a
10b
x
38
z
y

FIG. 7B

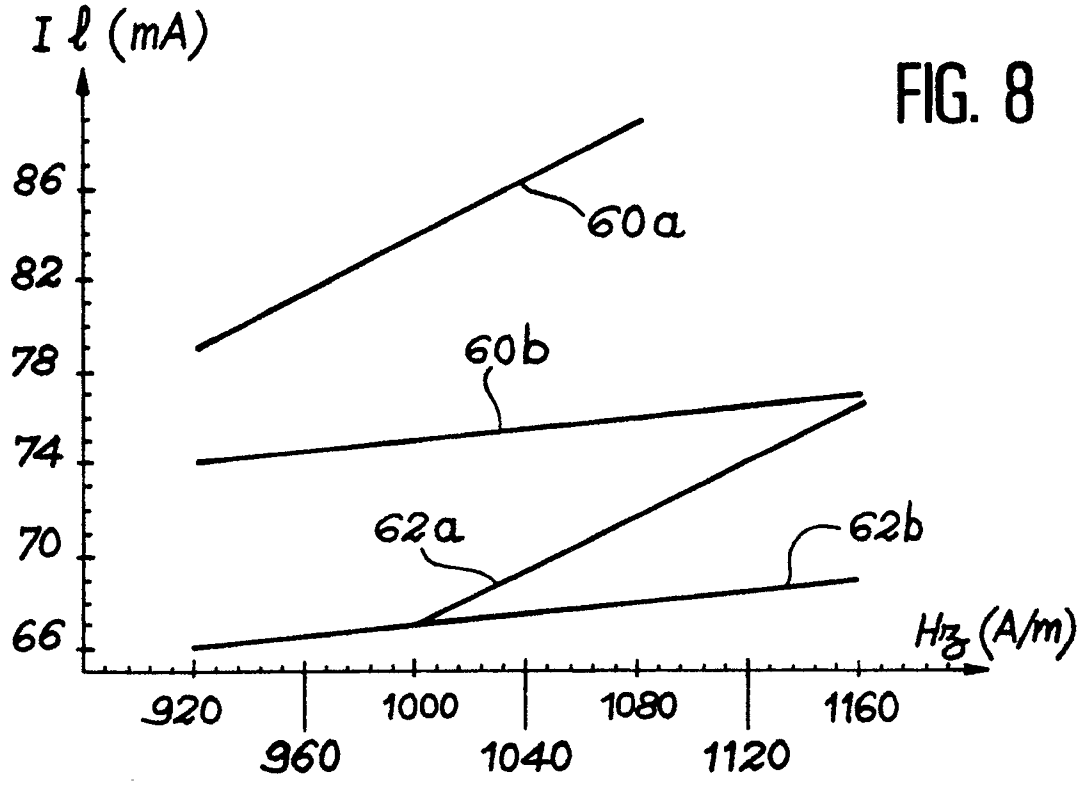

I ℓ (mA)
86
82
78
74
70
66
60a
60b
62a
62b
Hz (A/m)
920
960
1000
1040
1080
1120
1160


FIG. 8

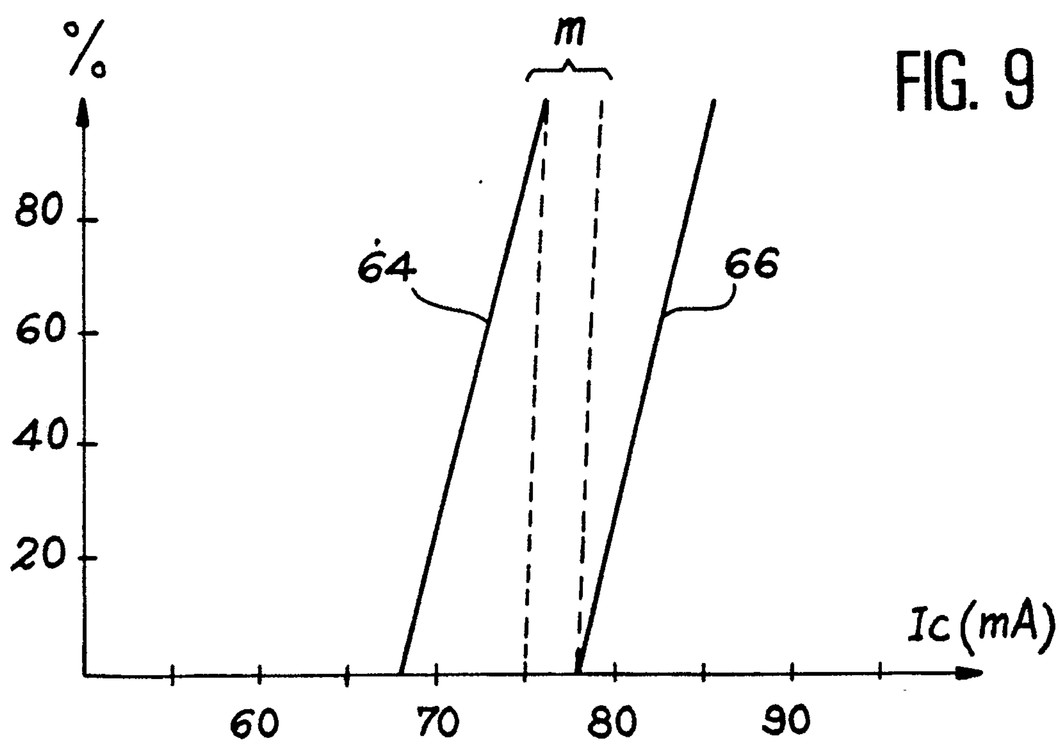

%
m
80
60
40
20
64
66
Ic (mA)
60
70
80
90


FIG. 9

Office européen des brevets

# RAPPORT DE RECHERCHE EUROPEENNE

Numéro de la demande

**EP 90 40 2462**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | JAPANESE JOURNAL OF APPLIED PHYSICS, vol. 25, no. 3, part 2, mars 1986, lignes L228-L231, Tokyo, JP; Y. HIDAKA: "A bloch line pair generator using the flank wall near the stripe domain head for the bloch line memory" * Page L229, colonne de gauche, ligne 13 - colonne de droite, ligne 5 * | 1 | G 11 C 19/08 |
| A | IDEM | 6 | |
| Y | ELECTRONIC PRODUCT DESIGN, octobre 1985, pages 69-72, Bromley, GB; W. CLEGG: "Vertical bloch line memory theory and technology" * Pages 69-70; figures 1-4 * | 1 | |
| A | IEEE TRANSACTIONS ON MAGNETICS, vol. 10, no. 4, décembre 1974, pges 1071-1079, IEEE, New York, US; W. KINSNER et al.: "Bubble cutting circuits" * Page 1074, colonne de droite, ligne 16 - page 1075, colonne de droite, ligne 3; figures 4-7 * | 1 | |

DOMAINES TECHNIQUES RECHERCHES (Int. Cl.5)

G 11 C 19/08

Le présent rapport de recherche a été établi pour toutes les revendications

| Lieu de la recherche | Date d'achèvement de la recherche | Examinateur |
|---|---|---|
| La Haye | 21 décembre 90 | DEGRAEVE L.W.G. |

CATEGORIE DES DOCUMENTS CITES

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention

E: document de brevet antérieur, mais publié à la date de dépôt ou après cette date
D: cité dans la demande
L: cité pour d'autres raisons

&: membre de la même famille, document correspondant